Europäisches Patentamt

**(19)** European Patent Office

Office européen des brevets

**(11)** Publication number : **0 487 338 B1**

**(12)** # EUROPEAN PATENT SPECIFICATION

**(45)** Date of publication of patent specification :
**11.01.95 Bulletin 95/02**

**(51)** Int. Cl.⁶ : **H05B 3/06,** H05B 3/14, H05B 3/36

**(21)** Application number : **91310723.1**

**(22)** Date of filing : **21.11.91**

**(54)** A thin film conductive device and method of manufacture thereof.

**(30)** Priority : **21.11.90 US 616587**

**(43)** Date of publication of application :
**27.05.92 Bulletin 92/22**

**(45)** Publication of the grant of the patent :
**11.01.95 Bulletin 95/02**

**(84)** Designated Contracting States :
**AT BE CH DE DK ES FR GB GR IT LI LU NL SE**

**(56)** References cited :
EP-A- 0 025 755
FR-A- 2 282 205
US-A- 4 593 181
US-A- 4 690 872
PATENT ABSTRACTS OF JAPAN vol. 14, no.
150 (P-1025)(4093) 22 March 1990 & JP-A-02
010 333 (SHARP CORP.) 16 January 1990.

**(73)** Proprietor : **FLEX PRODUCTS, INC.**
**2793 Northpoint Parkway**
**Santa Rosa California 95407 (US)**

**(72)** Inventor : **Parker, Robert**
**411 Rolling Hills Lane**
**Alamo, California 94507 (US)**
Inventor : **Phillips, Roger W.**
**466 Jacqueline Drive**
**Santa Rosa, California 95405 (US)**

**(74)** Representative : **Bayliss, Geoffrey Cyril et al**
**BOULT, WADE & TENNANT**
**27 Furnival Street**
**London EC4A 1PQ (GB)**

EP 0 487 338 B1

## Description

This invention relates to a substrate with a thin film conductive layer with a highly conductive bus bar and method for making the same.

Heating devices which are comprised of a flexible substrate with a thin film conductive layer thereon have heretofore been provided, as for example as disclosed in US-A-4,485,397 and 4,656,339 and also marketed by Flexwatt, 2380 Cranberry Highwey, West Warhams, Massachusetts 02576, or 611 Naponset Street, Taunton, Massachusetts 02021. It is believed that this product utilizes a carbon loaded polymer which is printed onto the surface of a flexible sheet to provide the resistive element. However, because of the polymer utilized, the material of the heating device has a tendency to break down at elevated temperatures, thus limiting heaters made from such a product to low temperature applications. In order to establish contact on the carbon loaded polymer, bus bars are mechanically laid down on the carbon loaded polymer. Hot spots occur in such arrangements. Because of different coefficients of expansion for the materials, there is a tendency for the material to delaminate and degrade. There is therefore a need for a new and improved substrate with thin film conductive layer and a highly conductive bus bar and a method for making the same.

In general, it is an object of the present invention to provide a thin film conductive device which has a highly conductive bus bar and a method for making the same.

Another object of the invention is to provide a thin film conductive device and method of the above character in which a plurality of highly conductive bus bars are provided.

Another object of the invention is to provide a thin film conductive device and method of the above character in which the bus bars are evaporated onto the thin film.

Another object of the invention is to provide a thin film conductive device and method of the above character in which highly resistant conductive films are utilized.

Another object of the invention is to provide a thin film conductive device and method of the above character in which the thin films can be formed in a predetermined pattern.

Another object of the invention is to provide a thin film conductive device and method of the above character in which high temperature heaters can be provided.

Another object of the invention is to provide a thin film conductive device and method of the above character in which the bus bars can readily have solder applied to them to increase their cross sectional area.

Another object of the invention is to provide a thin film conductive device and method of the above character which is suitable for use in many applications.

Another object of the invention is to provide a thin film conductive device and method of the above character in which a graduated thin film deposition is utilized.

Additional objects and features of the invention will appear from the following description in which the preferred embodiments are set forth in detail in conjunction with the accompanying drawings.

Figure 1 is an isometric view of a thin film conductive device incorporating the present invention.

Figure 2 is a greatly enlarged cross sectional view of a thin film device similar to that shown in Figure 1 incorporating the present invention.

Figure 3 is a schematic illustration of an apparatus which is utilized for performing the method of the present invention in the manufacture of thin film conductive devices incorporating the present invention.

Figure 4 is a plan view of the mask utilized in the apparatus shown in Figure 3.

Figure 5 is a isometric view in cross section of a thin film conductive device incorporating the present invention which is double sided.

Figure 6 is an isometric view partially in cross section of a thin film conductive device incorporating the present invention which utilizes a stacked geometry.

Figure 7 is an isometric view partially in cross section of still another embodiment of a flexible conductive thin film incorporating the present invention in which the thin film is striped and in which the bus bars are formed prior to the formation of the thin film.

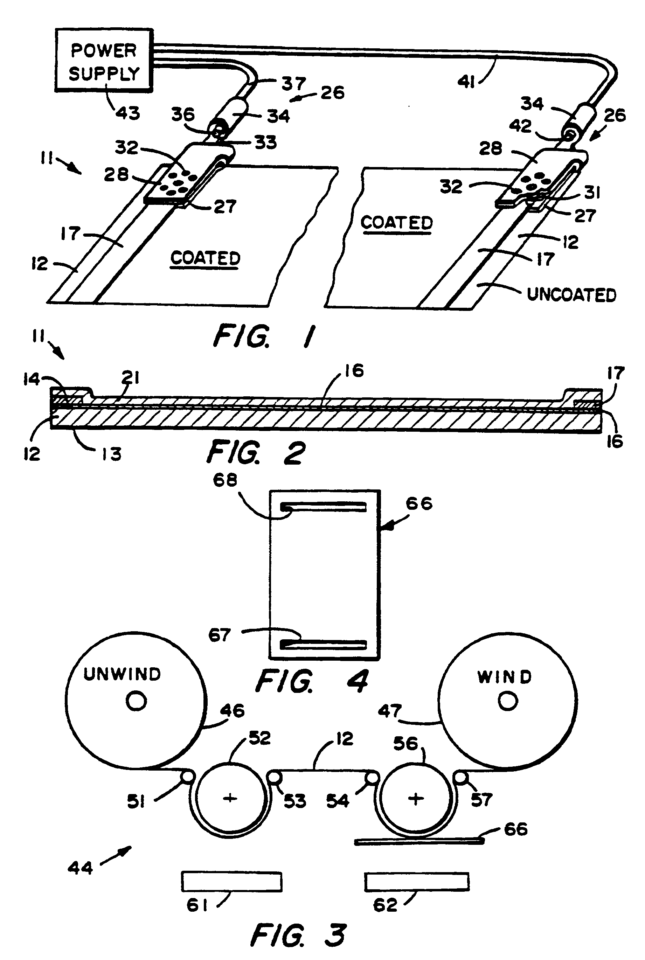

More specifically, as shown in Figure 1 of the drawings, a thin film conductive device 11 is shown which incorporates the present invention. It consists of a substrate 12 formed of a dielectric, insulating or nonconducting material which can be either opaque or transparent depending upon the desired application. Also it can be rigid or flexible. However, in many applications, it is believed that it is desirable to have the substrate be formed of a flexible material, as for example a plastic sheet formed of a polyester such as PET, a polyimide (e.g., Upilex) or polycarbonates. Plastics for high temperature applications are readily available for operation at temperatures as high as 200° C. High performance, high temperature films available from ICI can be used such as those in the Stabar series, namely polyethersulfone (PES) and polyetherether-ketone (FEEK), can be used. Upilex and Kapton, polyimides available from ICI and DuPont, respectively, could also serve as high temperature flexible substrates. Rolls of fiberglass cloth or paper could also be used for this application.

In applications where it is desired to utilize a roll coater, the substrate should have a thickness ranging from 25-178 μ (1 to 7 mils). The substrate 12 is provided with first and second surfaces 13 and 14. A thin film coating 16 is formed on the surface 14. The coating 16 is typically a vacuum deposited coating such as accomplished, by way of example, by sputtering, electron beam bombardment and resistive heating, and is comprised of a material or materials having relatively poor conductivity. Materials which are suitable for such a purpose include the following: stainless steel (72), Nichrome (-10), carbon (1375), chromium (13), titanium (43), indium-tin oxide (-10), tantalum (12.4), manganese (185), Inconel (122), carbon steel (10), iron (9.7), tin (11), and Monel (58). The resistivities are given in parenthesis in units of micro ohm-centimeters at room temperature. Indium tin oxide is a transparent oxide and is referred to as ITO in the thin film field. Thus, the materials that could be used as the thin film heating element are those that have resistivities in the range of 10-1500 micro ohm-centimeters. Typically, such coatings have a preferable thickness ranging from 50 to 500 Å.

Conductive bus bars 17 are formed on the thin film coating 16 and make intimate electrical contact therewith. As shown in the drawings, the bus bars 17 are generally rectangular in cross section. It should be appreciated that, if desired, the bus bars can be tapered by appropriate masking. For example, the bus bars can be thicker at the outer margin and progressively thinner away from the outer margin so that the bus bar has a substantially triangular appearance in cross section. To accomplish an intimate electrical contact with the thin film coating, a conductive metal is evaporated in a vacuum chamber to a suitable thickness, such as 1000 to 10,000 Å, and preferably, as shown, deposited at the edges of the subtrate 12 (as shown in Figures 1 and 2). The bus bar 17 can be formed of a suitable conductive metal, such as copper (1.5), silver (1.5), gold (2.0), aluminum (2.4), tin (11.0), lead/tin alloy (15), indium/tin alloy (10), and chromium (13). The numbers in parenthesis refer to the resistivity of the metal in micro ohm-centimeters at room temperature. Thus, the bus bars may have a range of resistivities of 1.5 to 15 micro ohm-centimeters.

The bus bar metal is deposited in a vacuum in a suitable manner such as by the use of resistive sources, electron gun sources or by sputtering. The bus bars 17 can be deposited during the same pass through a roll coater in a vacuum chamber. Alternatively, it can be accomplished in a second or later pass after the resistive thin film coating 16 has been applied as hereinafter descrived.

By way of example, copper bus bars were deposited by sputtering directly onto stainless steel. The stainless steel thickness was in the range of 50-250 Å. The copper was deposited to a thickness of 1000-7000 Å with the thickness depending on the resistance of the film on which it was deposited. When certain other materials were used for the thin film coating, such as ITO and I-80 (a transparent conductive film produced by Flex Products, Inc.), it was found desirable to use an intermediate bonding or adhesive layer of stainless steel having a thickness ranging from 50-250 Å before depositing the copper for the bus bars.

The bond which is formed between the deposited bus bar 17 and the thin film coating 16 provides a strong bond which survives slow and quick tape tests using either 850 or 610 tape manufactured by 3M.

In order to protect the thin film coating 16 from scratches, a protective overcoat 21 is provided which also can be deposited in a vacuum chamber. The overcoat 21 can be formed of a suitable dielectric material such as silicon dioxide, or $SiO_x$, to a suitable thickness ranging from 500 to 10,000 Å. Alternatively, a high temperature polyimide coating could be applied by wet chemical coating methods.

In order to establish electrical contact to the bus bars 17, suitable connecting means can be provided, as for example conventional clamp-type connectors 26 supplied by AMP which are provided with two portions 27 and 28 which can be folded over onto each other and which are provided with projections 31 which can extend through the conducting bus bar 17 and make electrical contact therewith, and extend into holes 32 provided in the other leaf 28. The leaves 27 and 28 are formed integral with an extension 33 which has formed thereon a fitting 34 which can be clamped into engagement with a conducting wire 36 of an insulated conductor 37. Another insulated conductor 41 having a conducting wire 42 is connected to the other connector 26 as shown in Figure 1. The conductors 37 and 41 are adapted to be connected to a suitable source of power represented by power supply 43 so that a potential, as for example 6 to 240 volts, is applied across the two bus bars 17.

In Figure 3, there is shown a schematic illustration of a roll coating apparatus or a roll coater 44 which can be utilized for manufacturing the thin film devices shown in Figures 1 and 2. This apparatus 44 consists of first and second reels 46 and 47 which can be identified as unwind and wind reels. The unwind reel 46 carries the plastic substrats 12 which is to be coated. It travels from the bottom of the reel 46 over an idler 51 and under a cooled drum 52, then over another idler 53 after which it passes over an idler 54, under another cooled drum 56 and then over an idler 57 to the wind or windup reel 47.

The apparatus 44 is enclosed within a vacuum chamber (not shown) which can provide a suitable vacuum such as $133.3 \times 10^{-6}$ N/m² ($10^{-6}$ Torr). A sputtering target 61 is provided below the cooled drum 52 and another sputtering target 62 is provided below the cooled drum 56. The first target 61 carries the material which is to be used for the thin film low conductive or resistive coating 16. Thus it can carry a suitable material such as stainless steel. The target 62 carries the material for the bus bars 17 and can carry a suitable material such as copper. The stainless steel can be sputtered directly onto the exposed surface of the substrate 12 to provide thereon the thin film coating 16. Thereafter, the metal for the bus bars can be sputtered from the target 62 onto the surface 13 of the subtrate 12 on which the thin film coating 16 has already been deposited to provide the pair of bus bars 17 on opposite edges of the flexible substrats 12. This can be accomplished by utilizing a mask 66 of the type shown in Figure 4 in which there has been provided rectangular openings 67 and 68 on opposite edges of the same in alignment with the positions where the bus bars 17 are to be formed on the thin film coating 16.

It should be appreciated that where desired it is possible to use electron gun beams to evaporate material where that is desirable. For example, electron gun beam evaporation can be utilized for evaporating the copper so that it is deposited through the openings 67 and 68 and the mask 66.

It should be appreciated that in place of the two sputter targets 61 and 62 provided in Figure 3, multiple sputter targets, as for example eight or more separate sputter targets, can be utilized to obtain a faster throughput in the roll coater 44.

In addition it should be appreciated that a single cooled drum can be utilized rather than two cooled drums. With such an arrangement, the thin film coating 16 is deposited when the flexible substrate 12 is advanced from the unwind roll 46 to the windup roll 47 and thereafter the bus bars 17 are evaporated onto the thin film coating. Separate targets can be used for the bus bar material and the thin film coating while utilizing the same cooled drum by depositing the thin film coating material while unwinding the coated substrate from the unwind reel 46 to the wind reel 47 and thereafter depositing the bus bar material while unwinding the coated substrate 12 from the windup reel 47 to the unwind reel 46. Also, alternatively, two separate coating machines can be utilized in which the thin film coating 16 can be deposited in one coating machine and, thereafter, the bus bars 17 deposited in another coating machine.

To do the thin film coating and the bus bar applications in two separate passes may often be desirable because in most cases the bus bar will have a thickness substantially greater than that of the thin film coating. By way of example, a thin film coating of stainless steel (type 304) could have a thickness of 50 to 200 Å to provide a resistance of 50 to 250 ohms/square, whereas the copper bus bar could have a thickness of 1000 to 7000 Å. However, it is possible that such disparities in thickness between the thin film heater and the bus bars can be accommodated by properly regulating the sputtering targets, as for example by reducing the power to the sputtering target for the stainless steel and using increased power in the sputtering target for the copper.

It should be appreciated that the protective layer coating 21, rather than being deposited in a vacuum chamber, can also be achieved by taking a separate sheet of dielectric material, as for example plastic, and by heat laminating it to the substrate 12 carrying the thin film coating 16 so that it overlies the thin film coating. Alternatively, an adhesive can be utilized for bonding the sheets together to also obtain the same type of protection. Alternatively, the protection coating can be applied by printing or knife coating.

Because of the manner in which the thin film conductive device is constructed, it is very thin. For example, the substrate can be of a 12 μ (1/2 mil) polyester upon which there is a deposited coating of few Angstroms, and upon which is laminated another 12 μ (1/2 mil) thick layer of polyester to provide a sheet-like heater which is only slightly more than one mil in thickness. Because it is so thin the product can be utilized in many applications, as for example seats in automobiles to provide heat. In other words, the present invention can be practiced utilizing substrates in protective coverings of a fraction of a mil up to 10's of mils.

Connections can be made to the bus bar by removing portions of the protective layer 21 overlying the bus bar and soldering connections thereto. Alternatively, as shown in Figure 1, the AMP type connectors can be utilized as hereinbefore described.

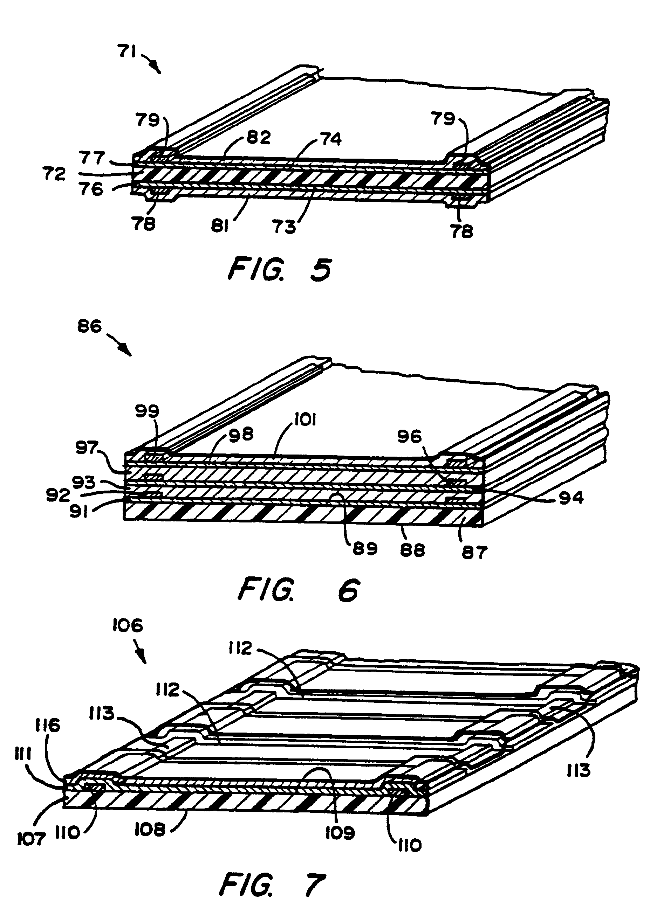

In Figure 5 there is shown another embodiment of the invention in which multiple heaters are provided on a single substrate. As shown therein, this device 71 consists of a substrate 72 of the type hereinbefore described, as for example a flexible polyester having first and second surfaces 73 and 74 and having formed thereon thin film conductive coatings 76 and 77 of the type hereinbefore described. Bus bare 78 of the type hereinbefore described are formed on the thin film coating 76 and similarly on the opposite side bus bars 79 are formed on the thin film coating 77. Protective layers 81 and 82 can be formed over the bus bars 78 and 79 and over the coatings 76 and 77 in the manner hereinbefore described to protect the coating 76 and 77.

Assuming that the device 71 is used as a heater, three different values of watt density can be obtained from such a heater assuming that the heater on one side of the substrate 72 has a different watt density than the heater on the other side of the substrate 72. Thus, when the bus bars 79 are connected to a source of power, one watt density is provided. Similarly, when the bus bars 78 are connected to a source of power another watt density is provided. And a third watt density can be obtained when both sets of bus bars 79 and 78 are connected to sources of power. Thus, it can be seen that when high warm up rates are desired, both sets of bus bars 78 and 79 can be connected to sources of power.

It also should be appreciated that the heaters of the present invention can be formed into a stacked device 86 as shown in Figure 6 in which a flexible plastic substrate 87 can be provided of the type hereinbefore described having surfaces 88 and 89. A thin film coating 91 of the type hereinbefore described is deposited on the surface 89, which is followed by spaced apart bus bars 92. Thereafter, a protective layer 93 is deposited over the coating 91 and the bus bars 92. The protective layer 93 is formed of a material which serves as an insulator or dielectric. A thin film optical coating 94 can then be deposited on the protective layer 93 followed by bus bars 96 of the type hereinbefore described. Bus bars 96 are followed by another protective layer 97 upon which there is deposited another thin film optical coating 98 of the type hereinbefore described. Bus bars 99 are formed on this coating. The bus bars 99 and the coating 98 are covered by a protective layer 101 of the type hereinbefore described. Thus, it can be seen that because of the relatively thin nature of the heaters, they can be readily stacked one above the other to provide additional watt capacity. Variations of the wattage of the heaters connected can be readily changed by connecting and disconnecting one or more sets of bus bars.

Another embodiment of the invention is shown in device 106 in Figure 7 in which a substrate 107 of the type hereinbefore described is provided having surfaces 108 and 109. Spaced apart parallel bus bars 110 are evaporated onto the surface 109 in a manner similar to that hereinbefore described. A patterned soluble release coat (not shown) is provided on the surface 109 and over the bus bars 110. The release coat can be comprised of poly(vinyl pyrrolidone) which is water soluble. Alternatively, it can be comprised of wax or acrylate type polymer which is soluble in a solvent. After the release coat has been formed with the desired patterning, as for example one having stripes therein and removed from over the bus bars 110, a thin film conductive coating 111 of the type hereinbefore described is deposited over the release coat and onto the bus bars 110 and onto the surface 109 where the release coat has been removed. The thin film conductive coating forms an intimate contact with the bus bars 110. After the coating 111 has been deposited, the portions of the coating 111 overlying the patterned release coat are removed in a solvent depending on the type of material utilized in the release coat so that there are provided stripes 112 of the thin film coating 111. As shown in Figure 7, these stripes 112 can be parallel and extend across the coating in one direction, as for example the width of the coating. A protective layer 116 of the type hereinbefore described is then formed over the thin film conductive coating 111.

By utilizing a device such as shown in Figure 7, additional advantages are achievable. By using a patterned thin film heater, patterned into stripes, one can use very thin conductive materials having low resistivities in the range given for the bus bar resistivities, namely 1.5-15 micro ohm-centimeters. Such an arrangement would allow use of the same material to be used for both the heater and bus bar. Adhesion between the heater and bus bar would be assured and coefficients of expansion for the heater and the bus bar would be the same which would result in good mechanical stability. Furthermore, by providing stripes 112, a scratch or crack in one stripe of the thin film conductive coating would be confined to that stripe and it would not be possible for the crack to propagate throughout the thin film heater.

When high temperature materials are utilized for the substrate, it is possible to build up the bus bars by solder adhering to the bus bars. For example, if stainless steel is used for the thin film coating and copper is used for the bus bars, the flexible web can be run through a bath of molten solder or through a wave soldering machine. The solder does not wet on the stainless steel but wets to and bonds to the copper bus bars so as to provide a much thicker bus bar in cross section when that is desired. In addition, the solder on the copper bus bar facilitates soldering of leads to the bus bar.

It should be appreciated in making the thin film conductive coatings, that the coatings can be a graduated in thickness if this is desired. This can be readily accomplished by utilizing appropriate masking in the coating machine. This masking can have apertures which will give the desired thickness contour. For example, it is readily possible to provide a thinner coating in the center than at the edges, which upon the application of power would give a heating distribution which would provide cooler temperatures at the edges and higher temperatures in the center. Such arrangements may be desirable, as for example in utilizing a transparent ITO for heaters for automobile and aircraft windshields to defrost the window starting at eye level and then defrosting in opposite directions up and down from eye level. Such an approach also makes it possible to save energy required to deice or defrost the windshield by selectively starting the deicing or defrosting operation in the region which is the most needed for viewing. Thus, in addition to using less energy, the defrosting or deicing is faster. Such graduated coatings can also be utilized in other applications where it is desired to provide more heating in certain areas than in others.

In automobile windshield applications, the deposition of a thin film conductive coating of variable thickness in which the thickness is thinner at the center, i.e. at eye level, makes it possible, in addition to obtaining the selected heating hereinbefore described, to have the top portion of the coating act as a solar control coating.

An effective summer solar control film composed of an all metal thin film coating is described in U.S. Patents Nos. 4,581,282, 4,463,047 and 4,536,998. In this arrangement, the top portion of the thick ITO is overcoated with a thin metal layer to reduce solar transmittance by absorption and reflection. This metal layer acts as if it were the "tint" in a "tinted" windshield.

The heating capabilities of thin film coatings in connection with the present invention can be described in the equation set forth below with the following parameters:

$R$ = Resistivity

$\rho$ = Resistivity in micro ohm-centimeters

$\rho_1$ = Sheet resistivity in ohms/$\square$

$L$ = Length in centimeters, which is the spacing between bus bars

$W$ = Width in centimeters, which is a measured distance perpendicular to the distance L

$E$ = Power in watts

$A_0$ = Current flow area

$A_1$ = Heated area

$E_1$ = Watt/density in watts/foot$^2$

$t$ = Conductor thickness in centimeters

$V$ = Voltage applied to the bus bars

The equations are as follows:

$$\text{Equation 1:} \qquad R = \rho \frac{L}{A_0}$$

$$\text{Equation 2:} \qquad R = \rho \frac{L}{Wt}$$

$$\text{Equation 3:} \qquad E = \frac{V^2}{R}$$

$$\text{Equation 4:} \qquad E_1 = \frac{E}{A} = \frac{V^2}{RA} \quad \text{(power density)}$$

$$\text{Equation 5:} \qquad E_1 = \frac{V^2}{RLW} = \frac{V^2}{\rho \frac{L}{Wt}} (LW)$$

$$\text{Equation 6:} \qquad E_1 = \frac{V^2}{\rho \frac{L^2}{t}} = \frac{V^2}{\rho_1 L^2}$$

$$\text{where } \rho_1 = \frac{V^2}{L^2 E_1}$$

By definition:

$$\frac{\rho}{t} = \rho_1 = \text{Sheet Resistivity } (\Omega/\square)$$

By way of example, to provide a heater which is 17 inches wide and has a desired watt density of 55 watts per square foot:

$$\rho_1 = \frac{(110)^2}{(2)(55)} = 110 \text{ ohms}/\square$$

$\rho$ = 72 micro ohm-cm for 304 stainless steel

The thickness t can be calculated as follows:

$$t = \frac{\rho}{\rho_1} = \frac{72 \times 10^{-6} \text{ cm}}{110} = 0.65 \times 10^{-6} \text{ cm}$$

since:

$$\text{Å} = 1 \times 10^{-10} \text{ M} = 1 \times 10^{-2} \text{ cm}$$

therefore

$$t = \frac{0.65 \times 10^{-6}}{1 \times 10^{-8}} = 65 \text{ Å of stainless steel}$$

Thus, 65 Å of stainless steel for the thin film coating would achieve the specified heating.

In another example, let it be assumed that it is desired to provide a heater which is 17 inches wide and has a length of 15 feet, and it is desired to determine the watt density at the distal extremity or the distal one-tenth. Assuming 1000 Å copper is utilized for the bus bars and that the bus bars are 3/4 of an inch wide, the following calculations can be made:

$$\rho \text{ copper} = 1.7 \text{ micro ohm - cm}$$

$$\rho_1 = \frac{1.7 \times 10^{-6}}{1000 \times 10^{-6}} = .17 \text{ ohms}/\square$$

The resistance of the copper is then calculated. From Equation 2, we have:

$$R = \frac{\rho L}{Wt} = \frac{\rho_1 L}{W}$$

In effect, the calculation assumes that the current passes down the 15 feet of one bus bar and returns an additional 15 feet on the other bus bar. Hence, L = 30 feet. Therefore,

$$R = \frac{(0.17 \times 30 \text{ ft}) (12 \text{ inches/ft})}{(0.75 \text{ inches})} = 81.6 \text{ ohms}$$

(1 inch = 25.4 mm)

(1 ft = 304.8 mm)

This result indicates that there is a considerable loss in power because the resistance of the heater is supposed to be 110 ohms. These losses can be overcome by utilizing wider bus bars, as for example bus bars 1.5 inches wide rather than 3/4 inch wide. For very long runs, it is desirable to increase the thickness of the bus bars, as for example by depositing solder on them in the manner hereinbefore described.

When utilizing transparent coatings, as for example for windshields, materials such as ITO can be utilised. It has been found that adequate power can be readily generated which is more than sufficient to melt ice.

From the foregoing it can be seen that there has been provided a particularly novel thin film conductive device and method by providing a thin film coating which is a relatively poor conductor and intimately connecting to it bus bars which have little relative resistance in comparison to the thin film conductive coating which is to be utilized as a heater. This makes it is possible to apply a substantially uniform voltage across the coating thereby distributing energy in a uniform manner to the coating to provide a heater surface which radiates heats substantially uniformly over the surface of the same. By utilizing flexible films for the substrate, it is possible to produce the heater in a continuous web process in which the thin film coating and the bus bars can be placed on the web in the same pass or in different passes in vacuum coating apparatus. The web material can then be chopped or cut into appropriate lengths to provide the desired heating capability. By selecting the spacing between the bus bars and by selecting the thickness of the thin film coating, it is possible to provide large combinations of watt densities, spacing and voltage requirements. With respect to certain coatings, as for example ITO, it may be desirable to provide the bus bars with a gradual transition when it meets the ITO to reduce the stiffness at that juncture and thereby avoid cracking of the ITO, which is a relatively brittle material.

The spacing between the bus bars can be such that they are disposed between 16-inch centers. Heater devices incorporating the present invention can be provided with the bus bars being within 16-inch centers and with portions of the substrate extending beyond the sides of the bus bars being free of the coating as shown in Figure 1 and then utilizing that substrate for nailing or gluing the heater to the studs.

Although the device of the present invention has primarily been discussed in connection with heaters, it is apparent that such a construction can have other applications, as for example for use in liquid crystal displays utilizing ITO coatings with a bus bar on one of the ends. However, in such liquid crystal displays, the same need for having intimate contact of the bus bar with the conductive element is very important. In such applications, it is only necessary to provide a single bus along one edge because it is only necessary to apply a uniform voltage to the device.

## Claims

1. A thin film conductive device (11) comprising a substrate (12) formed of a dielectric material and having first and second surfaces, a vacuum deposited thin film conductive coating (16) formed on one of said surfaces and a vacuum deposited bus bar (17) of conductive material adherent to said coating and making intimate contact therewith, said bus bar having a thickness which is substantially greater than that of the coating.

2. A device as in Claim 1 in which the bus bar (17) overlies the coating (16).

3. A device as in Claim 1 in which the bus bar (17) underlies the coating (16).

4. A device as in Claim 1 together with an additional vacuum deposited bus bar of conductive material formed on said coating and spaced apart from said first named bus bar, and means for applying a voltage to said first named and additional bus bars.

5. A device as in Claim 1 wherein said coating is comprised of a material which is a relatively poor conductor.

6. A device as in Claim 5 wherein said bus bar is formed of a material which is a relatively good conductor in comparison to the material utilized for the coating.

7. A device as in Claim 1 wherein said substrate is formed of a flexible material.

8. A device as in Claim 1 wherein said coating has a thickness ranging from 50 to 500 Å, and wherein said bus bars are formed to a thickness ranging from 1000 to 10,000 Å.

9. A device as in Claim 1 wherein said thin film coating is formed of a material selected from the group of stainless steel, nickel, Nichrome, silicon, carbon, chromium, titanium, indium tin oxide (ITO), tantalum, manganese, steel, tin and Monel.

10. A device as in Claim 1 wherein said bus bar is formed of a material selected from the group of copper, silver, gold, aluminum, tin, lead/tin alloy, indium/tin alloy, and chromium.

11. A device as in Claim 7 wherein the material after it is deposited has a resistivity ranging from 500 to 5000 micro ohm centimeters.

12. A device as in Claim 1 wherein said thin film coating is formed of stainless steel and wherein said bus bar is formed of copper.

13. A device as in Claim 1 wherein a protective layer overlies the thin film coating and the bus bars and is adherent thereto.

14. A device as in Claim 1 wherein a thin film coating is provided on the other surface of the substrate and vacuum deposited bus bars are provided on the second thin film coating making intimate contact therewith, and means for selecting applying power to the first set of bus bars and the second set of bus to provide different watt densities.

15. A device as in Claim 13 together with a thin film conductive coating deposited on the protective layer, vacuum deposited bus bars of conductive material formed on said additional thin film coating and in intimate contact therewith.

16. A device as in Claim 15 together with a protective layer overlying the additional thin film coating and the bus bars in contact therewith.

17. A device as in Claim 1 wherein the thin film coating is provided with a pattern.

18. A device as in Claim 17 wherein the pattern is in the form of stripes extending across the thin film coating and serving to inhibit the propagation of scratches in the thin film coating.

19. In a method for forming a thin film conductive device (11) on a flexible web-like substrate (12) having a surface, in which the web-like substrate (12) is disposed in a vacuum chamber and means is provided for advancing the web-like material from unwind and wind reels (46,47), the method comprising evaporating the material which is to be utilized as a thin film conductive coating onto the surface of the web while the web is being advanced in one direction, and evaporating another material for the bus bar to form a bus bar on one side of the web.

20. A method as in Claim 19 in which the thin film coating is deposited first followed by the bus bar.

21. A method as in Claim 19 in which the bus bar is deposited first followed by the thin film coating.

22. A method as in Claim 19 wherein the bus bar is deposited on the web as the web is moving in the same direction as when the thin film coating is being deposited thereon.

23. A method as in Claim 19 wherein the bus bar is deposited on the web when the web is moving in an opposite direction than when the thin film coating is being deposited thereon.

24. A method as in Claim 19 wherein the material which is utilized for the thin film coating is sputtered.

25. A method as in Claim 19 wherein the material utilized for the bus bar is sputtered.

26. A method as in Claim 19 wherein the material utilized for the bus bar is electron beam evaporated.

27. A method as in Claim 19 wherein the material utilized for the bus bar is resistively heated and evaporated.

28. A method as in Claim 19 wherein the thin film coating is deposited in selected areas of the web.

29. A method as in Claim 19 wherein the thin film coating is deposited in a graduated manner.

30. A method as in Claim 19 together with the step of forming a bonding layer between the bus bar and the thin film coating.

31. A method as in Claim 29 wherein the thin film coating is deposited by electron beam evaporation.


**Patentansprüche**

1. Leitfähiges Dünnflim-Bauelement (11) mit einem aus einem dielektrischen Material bestehenden Substrat (12), mit einer ersten und einer zweiten Oberfläche, einem im Vakuum aufgedampften auf einer der Oberflächen abgelagerten leitfähigen Dünnfilm-Beschichtung (16) und einer im Vakuum aufgedampften Sammelschiene (17) aus leitfähigem Material, die an der Beschichtung haftet und mit ihr in engem Kontakt steht, wobei die Sammelschiene eine wesentlich größere Dicke aufweist als die Beschichtung.

2. Bauelement nach Anspruch 1, bei dem die Sammelschiene (17) über der Beschichtung (16) liegt.

3. Bauelement nach Anspruch 1, bei dem die Sammelschiene (17) unter der Beschichtung (16) liegt.

4. Bauelement nach Anspruch 1, mit einer zusätzlichen im Vakuum aufgedampften, auf der Beschichtung aufgebrachten und von der zuerst genannten Sammelschiene entfernten Sammelschiene aus leitfähigem Material und mit einer Einrichtung zum Anlegen einer Spannung an die erste und die zusätzliche Sammelschiene.

5. Bauelement nach Anspruch 1, wobei die Beschichtung aus einem Material besteht, das ein verhältnismäßig schlechter Leiter ist.

6. Bauelement nach Anspruch 5, wobei die Sammelschiene aus einem Material ausgebildet ist, das ein verhältnismäßig guter Leiter im Vergleich zu dem für die Beschichtung verwendeten Material ist.

7. Bauelement nach Anspruch 1, wobei das Substrat aus einem flexiblen Material besteht.

8. Bauelement nach Anspruch 1, wobei die Beschichtung eine Dicke von 50 bis 500 Å aufweist und wobei die Sammelschiene mit einer Dicke von 1000 bis 10.000 Å ausgebildet ist.

9. Bauelement nach Anspruch 1, wobei die Dünnfilm-Beschichtung aus einem Material besteht, das der Gruppe aus nichtrostendem Stahl, Nickel, Nichrom, Silizium, Kohle, Chrom, Titan, Indium-Zinnoxid (ITO), Tantal, Mangan, Stahl, Zinn und Monel angehört.

10. Bauelement nach Anspruch 1, wobei die Sammelschiene aus einem Material besteht, das der Gruppe aus Kupfer, Silber, Gold, Aluminium, Zinn, Blei/Zinn-Legierung, Indium/Zinn-Legierung und Chrom angehört.

11. Bauelement nach Anspruch 7, wobei das Material nach der Ablagerung einen Widerstandswert von 500 bis 5000 Mikro-Ohm-cm aufweist.

12. Bauelement nach Anspruch 1, wobei die Dünnfilm-Beschichtung aus nichtrostendem Stahl und die Sammelschiene aus Kupfer ausgebildet ist.

13. Bauelement nach Anspruch 1, wobei eine Schutzschicht über der Dünnfilm-Beschichtung und den Sammelschienen liegt, die an diesen anhaftet.

14. Bauelement nach Anspruch 1, wobei eine Dünnfilm-Beschichtung auf der anderen Seite des Substrats vorgesehen ist und im Vakuum aufgedampfte Sammelschienen auf der zweiten Dunnfilm-Beschichtung in engem Kontakt dazu vorgesehen sind, sowie mit einer Einrichtung zum wahlweisen Anlegen von Spannung an die ersten Sammelschienen und die zweiten Sammelschienen zum Erzeugen verschiedener Watt-Dichten.

15. Bauelement nach Anspruch 13 mit einer leitfähigen, auf der Schutzschicht abgelagerten Dünnfilm-Beschichtung und mit im Vakuum aufgedampften, auf dieser zusätzlichen Film-Beschichtung ausgebildeten und in engem Kontakt mit dieser stehenden Sammelschienen aus leitfähigem Material.

16. Bauelement nach Anspruch 15 mit einer Schutzschicht über der zusätzlichen Dünnfilm-Beschichtung und den damit in Kontakt stehenden Sammelschienen.

17. Bauelement nach Anspruch 1, wobei die Dünnfilm-Beschichtung mit einem Muster versehen ist.

18. Bauelement nach Anspruch 17, wobei das Muster in Form von quer über die Dünnfilmbeschichtung laufenden Streifen zum Verhindern der Verbreitung von Kratzern in der Dünnfilm-Beschichtung ausgebildet ist.

19. Verfahren zum Ausbilden eines leitfähigen Dünnfilm-Bauelementes (11) auf einem flexiblen gewebeartigen Substrat (12) mit einer Oberfläche, bei dem das gewebeartige Substrat (12) in einer Vakuumkammer angeordnet ist und eine Einrichtung zum Transport des gewebeartigen Materials über Auf- und Abwickelspulen (46, 47) vorgesehen ist, wobei das Verfahren die folgenden Schritte umfaßt: Aufdampfen des Materials, das als leitfähige Dünnfilm-Beschichtung verwendet wird, auf die Oberfläche des Gewebes, während das Gewebe in eine Richtung weitertransportiert wird, und Aufdampfen eines weiteren Materials für die Sammelschiene, um auf einer Seite des Gewebes die Sammelschiene zu bilden.

20. Verfahren nach Anspruch 19, bei dem zuerst die Dünnfilm-Beschichtung und dann die Sammelschiene abgelagert wird.

21. Verfahren nach Anspruch 19, bei dem zuerst die Sammelschiene und dann die Filmbeschichtung abgelagert wird.

22. Verfahren nach Anspruch 19, bei dem die Sammelschiene auf dem Gewebe abgelagert wird, während sich das Gewebe in der gleichen Richtung wie bei der Ablagerung der Dünnfilm-Beschichtung gewegt.

23. Verfahren nach Anspruch 19, bei dem die Sammelschiene auf dem Gewebe abgelagert wird, während sich das Gewebe in der Richtung bewegt, die der Richtung der Ablagerung der Dünnfilm-Beschichtung entgegengesetzt ist.

24. Verfahren nach Anspruch 19, bei dem das für die Dünnfilm-Beschichtung verwendete Material gesputtert wird.

25. Verfahren nach Anspruch 19, bei dem das für die Sammelschiene verwendete Material gesputtert wird.

26. Verfahren nach Anspruch 19, bei dem das für die Sammelschiene verwendete Material elekronenstrahlverdampft wird.

27. Verfahren nach Anspruch 19, bei dem das für die Sammelschiene verwendete Material widerstandserwärmt und verdampft wird.

28. Verfahren nach Anspruch 19, bei dem die Dünnfilm-Beschichtung auf ausgewählten Bereichen des Gewebes abgelagert wird.

29. Verfahren nach Anspruch 19, bei dem die Dünnfilm-Beschichtung in abgestufter Weise abgelagert wird.

30. Verfahren nach Anspruch 19, zusätzlich mit dem Schritt, bei dem eine Bindeschicht zwischen der Sammelschiene und der Dünnfilm-Beschichtung gebildet wird.

31. Verfahren nach Anspruch 29, bei dem die Dünnfilm-Beschichtung durch Elektronenstrahlverdampfung abgelagert wird.

EP 0 487 338 B1

## Revendications

**1.** Dispositif conducteur (11) à couche mince comportant un substrat (12) formé d'une matière diélectrique et ayant des première et seconde surfaces, un revêtement conducteur (16) en couche mince déposé sous vide, formé sur l'une desdites surfaces et une barre omnibus (17) déposée sous vide en matière conductrice adhérant audit revêtement et réalisant un contact intime avec lui, ladite barre omnibus ayant une épaisseur qui est sensiblement supérieure à celle du revêtement.

**2.** Dispositif selon la revendication 1, dans lequel la barre omnibus (17) s'étend au-dessus du revêtement (16).

**3.** Dispositif selon la revendication 1, dans lequel la barre omnibus (17) s'étend au-dessous du revêtement (16).

**4.** Dispositif selon la revendication 1, avec une barre omnibus additionnelle déposée sous vide en matière conductrice formée sur ledit revêtement et espacée de ladite barre omnibus première citée, et des moyens pour appliquer une tension auxdites barres omnibus première citée et additionnelle.

**5.** Dispositif selon la revendication 1, dans lequel ledit revêtement est constitué d'une matière qui est un conducteur relativement mauvais.

**6.** Dispositif selon la revendication 5, dans lequel ladite barre omnibus est formée d'une matière qui est un conducteur relativement bon en comparaison avec la matière utilisée pour le revêtement.

**7.** Dispositif selon la revendication 1, dans lequel ledit substrat est formé d'une matière flexible.

**8.** Dispositif selon la revendication 1, dans lequel ledit revêtement présente une épaisseur allant de 50 à 500 Å, et dans lequel lesdites barres omnibus sont formées à une épaisseur allant de 1000 à 10 000 Å.

**9.** Dispositif selon la revendication 1, dans lequel ledit revêtement à couche mince est formé d'une matière choisie dans le groupe constitué de l'acier inoxydable, du nickel, du Nichrome, du silicium, du carbone, du chrome, du titane, de l'oxyde d'étain dopé à l'indium (ITO), du tantale, du manganèse, de l'acier, de l'étain et du Monel.

**10.** Dispositif selon la revendication 1, dans lequel ladite barre omnibus est formée d'une matière choisie dans le groupe constitué du cuivre, de l'argent, de l'or, de l'aluminium, de l'étain, d'un alliage plomb/étain, d'un alliage indium/étain et du chrome.

**11.** Dispositif selon la revendication 7, dans lequel la matière, après avoir été déposée, présente une résistivité allant de 500 à 5000 micro-ohms.centimètres.

**12.** Dispositif selon la revendication 1, dans lequel ledit revêtement en couche mince est formé d'acier inoxydable et dans lequel ladite barre omnibus est formée de cuivre.

**13.** Dispositif selon la revendication 1, dans lequel une couche protectrice s'étend au-dessus du revêtement en couche mince et des barres omnibus et y adhère.

**14.** Dispositif selon la revendication 1, dans lequel un revêtement en couche mince est prévu sur l'autre surface du substrat et des barres omnibus déposées sous vide sont prévues sur le second revêtement en couche mince, réalisant un contact intime avec lui, et des moyens destinés à sélectionner une puissance appliquée au premier jeu de barres omnibus et au second jeu de bus pour établir des densités de puissance différentes.

**15.** Dispositif selon la revendication 13, avec un revêtement conducteur en couche mince déposé sur la couche protectrice, des barres omnibus déposées sous vide en matière conductrice formées sur ledit revêtement additionnel en couche mince et en contact intime avec lui.

**16.** Dispositif selon la revendication 15, avec une couche protectrice s'étendant au-dessus du revêtement additionnel en couche mince et des barres omnibus en contact avec eux.

11

**17.** Dispositif selon la revendication 1, dans lequel le revêtement en couche mince présente un motif.

**18.** Dispositif selon la revendication 17, dans lequel le motif se présente sous la forme de raies s'étendant à travers le revêtement en couche mince et servant à empêcher la propagation de rayures dans le revêtement en couche mince.

**19.** Procédé pour former un dispositif conducteur (11) à couche mince sur un substrat flexible (12) analogue à une bande ayant une surface, dans lequel le substrat (12) analogue à une bande est disposé dans une chambre à vide et des moyens sont prévus pour faire avancer la matière analogue à une bande d'une bobine débitrice (46) à une bobine réceptrice (47), le procédé consistant à faire évaporer la matière qui doit être utilisée en tant que revêtement conducteur en couche mince sur la surface de la bande pendant que la bande est avancée dans un sens, et à évaporer une autre matière pour la barre omnibus afin de former une barre omnibus sur un côté de la bande.

**20.** Procédé selon la revendication 19, dans lequel le revêtement en couche mince est déposé en premier, suivi de la barre omnibus.

**21.** Procédé selon la revendication 19, dans lequel la barre omnibus est déposée en premier, suivie du revêtement en couche mince.

**22.** Procédé selon la revendication 19, dans lequel la barre omnibus est déposée sur la bande pendant que la bande est en mouvement dans le même sens que lorsque le revêtement en couche mince est déposé sur elle.

**23.** Procédé selon la revendication 19, dans lequel la barre omnibus est déposée sur la bande lorsque la bande est en mouvement dans un sens opposé à celui suivi lorsque le revêtement en couche mince est déposé sur elle.

**24.** Procédé selon la revendication 19, dans lequel la matière qui est utilisée pour le revêtement en couche mince est appliquée par pulvérisation.

**25.** Procédé selon la revendication 19, dans lequel la matière utilisée pour la barre omnibus est appliquée par pulvérisation.

**26.** Procédé selon la revendication 19, dans lequel la matière utilisée pour la barre omnibus est évaporée par faisceau électronique.

**27.** Procédé selon la revendication 19, dans lequel la matière utilisée pour la barre omnibus est chauffée par effet Joule et évaporée.

**28.** Procédé selon la revendication 19, dans lequel le revêtement en couche mince est déposé sur des zones choisies de la bande.

**29.** Procédé selon la revendication 19, dans lequel le revêtement en couche mince est déposé d'une manière graduée.

**30.** Procédé selon la revendication 19, associé à l'étape qui consiste à former une couche de liaison entre la barre omnibus et le revêtement en couche mince.

**31.** Procédé selon la revendication 29, dans lequel le revêtement en couche mince est déposée par évaporation par faisceau électronique.

FIG. 1

FIG. 2

FIG. 4

FIG. 3

FIG. 5

FIG. 6

FIG. 7